# EUROPEAN PATENT SPECIFICATION

(11) **EP 4 611 033 B1**
(45) Date of publication and mention of the grant of the patent: **04.11.2026**
(21) Application number: 24203180.5
(22) Date of filing: 27.09.2024
(51) Int. Cl.: H10W 40/22, H10W 40/25, H10W 40/70, H10W 40/77

(54) **HEAT SINK CONFIGURED TO TRANSFER HEAT AND OIL AWAY FROM AN INTEGRATED CIRCUIT**
KÜHLKÖRPER ZUR ÜBERTRAGUNG VON WÄRME UND ÖL VON EINER INTEGRIERTEN SCHALTUNG
DISSIPATEUR THERMIQUE CONÇU POUR TRANSFÉRER DE LA CHALEUR ET DE L'HUILE À L'ÉCART D'UN CIRCUIT INTÉGRÉ

(30) Priority: 28.02.2024 US 202418589682
(43) Date of publication of application: 03.09.2025
(73) Proprietor: Aptiv Technologies AG, 8200 Schaffhausen (CH)
(72) Inventor: Macfarland, Sophie, Indianapolis, IN, 46240 (US); Rumreich, Marlow, Fishers, IN, 46038 (US); Diaz, Joseph Brian, Carmel, IN, 46032 (US)
(74) Representative: Manitz Finsterwald Patent- und Rechtsanwaltspartnerschaft mbB

(56) References cited:
- US-A1- 2005 263 879
- US-A1- 2010 246 133
- US-A1- 2019 249 007

## Description

### FIELD

The present disclosure relates to a heat sink configured to transfer oil away from an integrated circuit.

### BACKGROUND

This section provides background information related to the present disclosure, which is not necessarily prior art.

A heat sink is a device configured to cool an integrated circuit (IC) mounted to a circuit board. The heat sink dissipates heat away from the IC to prevent the IC from overheating. Between the heat sink and the IC is typically a thermal interface material (TIM). The TIM improves thermal conductivity between the IC and the heat sink. The TIM may include pastes or gels having thermally conductive particles (such as metal oxides, sliver, or ceramics) suspended in a polymer carrier.

US2010246133 A1 and US2005263879 A1 disclose heat sinks attached to integrated circuits through TIM layers, the heat sinks having patterned contact surfaces for an efficient TIM distribution. US2019249007 A1 discloses a TIM layer whose composition reduces TIM bleeding.

### SUMMARY

This section provides a general summary of the disclosure, and is not a comprehensive disclosure of its full scope or all of its features.

The present disclosure provides for, in various features, a heat sink configured to transfer heat away from an integrated circuit. The heat sink includes: a base configured to be mounted over the integrated circuit in contact with thermal interface material on the integrated circuit; a sidewall extending from the base; and a capillary channel extending along the base away from the integrated circuit, the capillary channel configured to draw oil released from the thermal interface material away from the integrated circuit by capillary action.

In further features, the capillary channel extends from the base to the sidewall and along the sidewall.

In further features, the capillary channel extends along the base to both the sidewall and an additional sidewall of the heat sink.

In further features, the capillary channel is one of a plurality of capillary channels extending from the base to both the sidewall and an additional sidewall of the heat sink.

In further features, the capillary channel extends continuously from the base to the sidewall, and the sidewall is oriented 90° relative to the base.

In further features, at the base at least a portion of the capillary channel has the thermal interface material therein.

In further features, the heat sink further comprises a pedestal including the base, and a plurality of sidewalls including the sidewall.

In further features, the heat sink comprises a cover; the pedestal extends from the cover; and the capillary channel extends from the base to the sidewall, from the sidewall to the cover, and along a surface of the cover.

In further features, the capillary channel is an open channel.

In further features, the capillary channel is an open channel including a radius of 0.3mm - 2.5mm.

In further features, the capillary channel is an open channel including one of an open cylinder, an open elliptical cylinder, an open irregular channel geometry, an open triangular prism, an open rectangular prism, an open square prism, an open pentagonal prism, and an open hexagonal prism.

In further features, the capillary channel is a closed channel at the sidewall and an open channel at the base.

In further features, the capillary channel is a closed channel at the sidewall including a radius of 0.3mm - 2.5mm.

In further features, the capillary channel is an open channel at the base; and the capillary channel is a closed channel at the sidewall including one of a closed cylinder, a closed elliptical cylinder, a closed irregular channel geometry, a closed triangular prism, a closed square prism, a closed rectangular prism, a closed pentagonal prism, a closed hexagonal prism, a closed heptagonal prism, a closed octagonal prism, a closed nonagonal prism, and a closed decagonal prism.

The present disclosure also includes, in various features, a heat sink configured to transfer heat away from an integrated circuit mounted to a circuit board. The heat sink includes: a base configured to be mounted over the integrated circuit and the circuit board in contact with thermal interface material on the integrated circuit; a plurality of sidewalls extending from the base, the plurality of sidewalls and the base defining a heat sink pedestal; and a plurality of capillary channels extending from the base to and along at least one of the plurality of sidewalls, the plurality of capillary channels configured to draw oil released from the thermal interface material away from the integrated circuit and the circuit board by capillary action.

In further features, the plurality of capillary channels are open channels at the base and open channels at the plurality of sidewalls.

In further features, the plurality of capillary channels are open channels at the base and closed channels at the plurality of sidewalls.

The present disclosure also includes, in various features, a heat sink configured to transfer heat away from an integrated circuit mounted to a circuit board. The heat sink includes a cover and a pedestal extending from the cover towards the integrated circuit. The pedestal includes: a base configured to be mounted over the integrated circuit in contact with thermal interface material on the integrated circuit; a plurality of sidewalls extending from the base; and a plurality of capillary channels extending continuously from the base to at least two of the plurality of sidewalls, along the at least two of the plurality of sidewalls, and along the cover. The plurality of capillary channels are configured to draw oil released from the thermal interface material into the plurality of capillary channels and along the plurality of capillary channels away from the integrated circuit by capillary action.

In further features, the plurality of capillary channels are open channels at the base, and are open channels or closed channels along the at least two of the plurality of sidewalls and along the cover.

In further features, the open channels have a first radius that is less than a second radius of the closed channels.

### DRAWINGS

The drawings described herein are for illustrative purposes only of select embodiments and not all possible implementations.
FIG. 1 is a perspective view of a heat sink in accordance with the present disclosure, and a circuit board including an integrated circuit (IC) to be cooled by the heat sink;
FIG. 2 is a perspective view of the heat sink over the IC with a thermal interface material (TIM) therebetween;
FIG. 3 is a perspective view showing interaction between the heat sink, the IC, and the TIM therebetween;
FIGS. 4A-4H are cross-sectional views of exemplary open capillary channels defined by the heat sink in accordance with the present disclosure; and
FIGS. 5A-5L are cross-sectional views of exemplary closed capillary channels defined by the heat sink in accordance with the present disclosure.

Corresponding reference numerals indicate corresponding parts throughout the several views of the drawings.

### DETAILED DESCRIPTION

Example embodiments will now be described more fully with reference to the accompanying drawings.

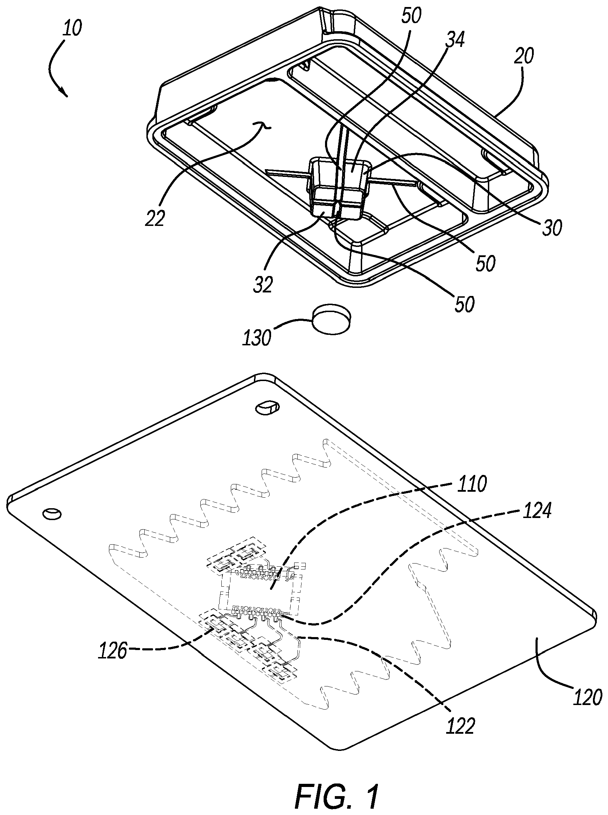

FIG. 1 illustrates an exemplary heat sink 10 in accordance with the present disclosure configured to transfer heat away from an integrated circuit (IC) 110 to cool the IC 110. The IC 110 is mounted to a circuit board 120. Between the IC 110 and the heat sink 10 is a thermal interface material (TIM) 130. The circuit board 120 includes a plurality of traces 122, which extend from connector pads 124 in contact with the IC 110 to distal connector pads 126. As explained herein, the heat sink 10 is configured to draw oil released from the TIM 130 away from the IC 110, the connector pads 124, the traces 122, and the circuit board 120 generally to prevent the oil from interfering with operation of the IC 110 and/or the circuit board 120.

The IC 110 may be any suitable IC configured for use in any suitable application. For example, the IC 110 may be configured as a microprocessor, a memory chip, a microcontroller, a digital signal processor, an analog integrated circuit, a radio frequency integrated circuit, a power management integrated circuit, a sensor integrated circuit, etc. When configured as a radio frequency integrated circuit, the IC 110 may be used in radar systems (such as vehicle radar systems configured for use with vehicle driver assistance systems and/or self-driving systems) or wireless communication systems for transmitting and receiving radio signals. Examples include RF transceivers, power amplifiers, and frequency synthesizers, such as those used in cell phones, Wi-Fi routers, and satellite communication systems. When configured as a sensor or sensor interface integrated circuit, the IC 110 may be configured to convert physical quantities such as temperature, pressure, light, and motion into electrical signals. Examples include temperature sensors, accelerometers, gyroscopes, and ambient light sensors used in smartphones, wearables, and automotive applications. The IC 110 may be particularly configured for use in automotive applications including, for example, advanced driver assistance systems, autonomous driving systems, vehicle connectivity systems, vehicle-to-vehicle communications, vehicle-to-infrastructure communication, and vehicle-to-everything communications.

The heat sink 10 includes a cover 20 with an inner surface 22. Extending from the inner surface 22 is a pedestal 30 of the heat sink 10. With the heat sink 10 mounted over the circuit board 120 and the IC 110, the pedestal 30 extends from the inner surface 22 towards the IC 110. The pedestal 30 includes a base 32 and a plurality of sidewalls 34 extending from the base 32 to the inner surface 22 of the cover 20. The base 32 lies in a plane that is parallel to, or generally parallel to, the inner surface 22. The sidewalls 34 are oriented 90° relative to the base 32 or at any other suitable angle. Any suitable number of sidewalls 34 may be included, such as three or more. In the example illustrated, the pedestal 30 includes four sidewalls 34.

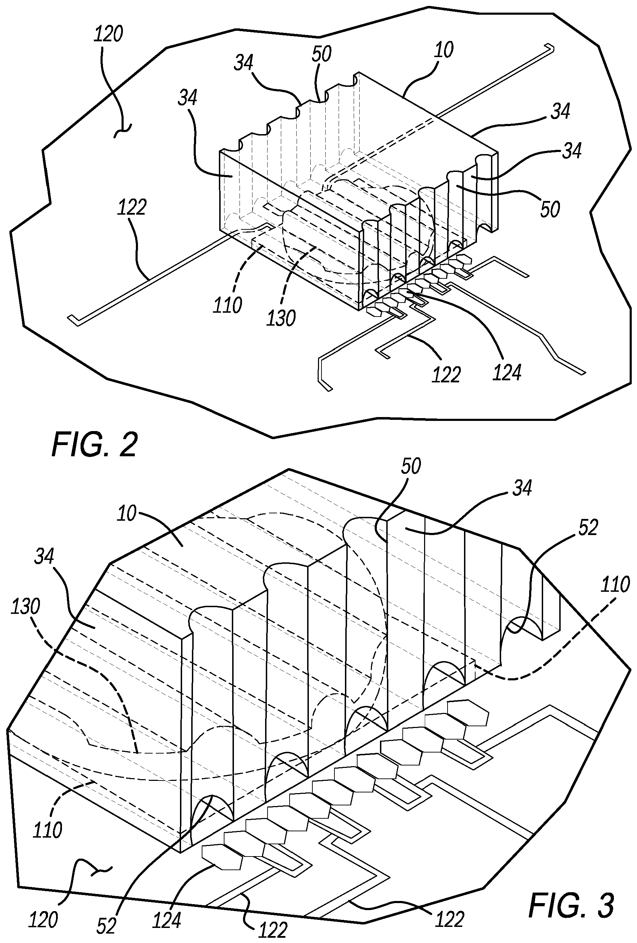

The pedestal 30 defines at least one capillary channel 50. Each capillary channel 50 extends along the base 32 away from the IC 110 and in a direction away from the pedestal 30. In various applications, each capillary channel 50 may be considered to extend towards one or more of the sidewalls 34. In the example illustrated in FIG. 1, each capillary channel 50 extends to one of the sidewalls 34, along the sidewalls 34 to the cover 20, and along a portion of the inner surface 22 of the cover 20 outward from the pedestal 30. FIG. 1 illustrates each sidewall 34 defining one capillary channel 50. In the example of FIGS. 2 and 3, the pedestal 30 defines a plurality of capillary channels 50 at opposing sidewalls 34, which also extend along the base 32. In some applications, one or more of the capillary channels 50 may only extend along a portion of the base 32 away from the IC 110 and in a direction away from the pedestal 30 (towards one of the sidewalls 34, for example), and may terminate prior to reaching the sidewalls 34. In other applications, one or more of the capillary channels 50 may extend to the sidewalls 34 and terminate at the sidewalls 34. In still other applications, one or more of the capillary channels 50 may extend along the base 32, along the sidewalls 34, and terminate at the inner surface 22 of the cover 20 or prior to reaching the inner surface 22. In the examples illustrated, the capillary channels 50 extend along the sidewalls 34 adjacent to the connector pads 124. The capillary channels 50 may also extend from the base 32 to the sidewalls 34 that are not adjacent to the connector pads 124.

The capillary channels 50 may include a transition surface 52 (FIG. 3) where the capillary channels 50 transition and turn from the base 32 to the sidewalls 34. The transition surface 52 may be rounded from the base 32 to the sidewall 34 to facilitate movement of oil by capillary action.

The TIM 130 is deposited on the IC 110 and is in contact with the base 32. At least a portion of the capillary channels 50 at the base 32 include the TIM 130 therein. The TIM 130 improves thermal conductivity between the IC 110 and the base 32 of the pedestal 30. The TIM 130 may include a silicone polymer base matrix. The polymer of the TIM 130 includes a variety of chain lengths, including long, or very crosslinked chains, as well as short, low-molecular weight segments (LMWs). This spread allows for greater flexibility of the polymer matrix. LMWs may be volatile and cause the TIM 130 to have outgassing. LMWs are also liable to be liquid, and are an oil component of the TIM 130. The oil may seep out of the TIM 130 and spread across the circuit board 120, which may impact performance. Performance may be particularly affected when the circuit board 120 is configured as a radar circuit board. Organic and silicone oils have low surface energies (though silicone oil is typically lower than organic oils), which makes their spreading across the circuit board 120 energetically favorable. This may become an issue when liquid oil from the TIM 130 covers the traces 122 configured as radio-frequency traces. The dielectric constant (Dk) of the oil is substantially different from that of air, so when the oil covers RF traces it may cause a shift leading to angle accuracy issues for a radar. The capillary channels 50 are configured to, by capillary action, draw the oil released from the TIM 130 away from the IC 110, away the circuit board 120, away from the connector pads 124, and away from the traces 122. The portions of the capillary channels 50 at the inner surface 22 of the cover 20 are configured to draw the oil away from the pedestal 30.

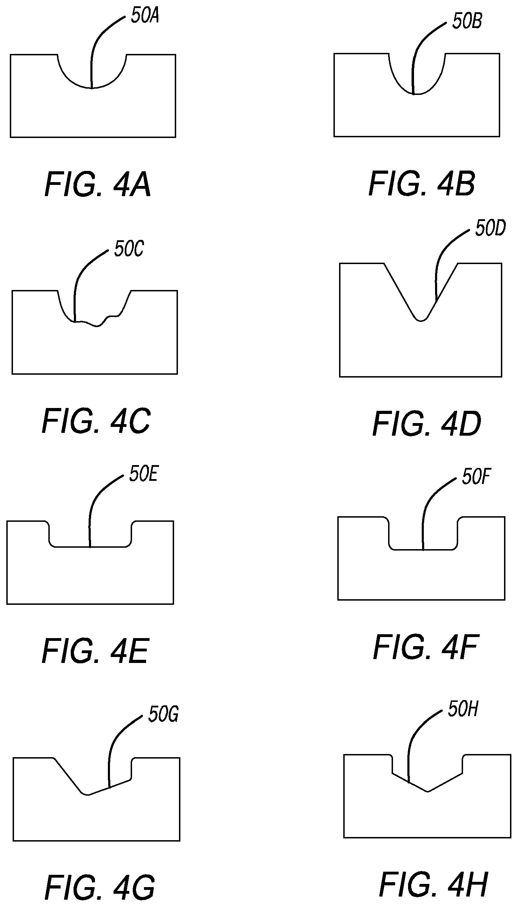

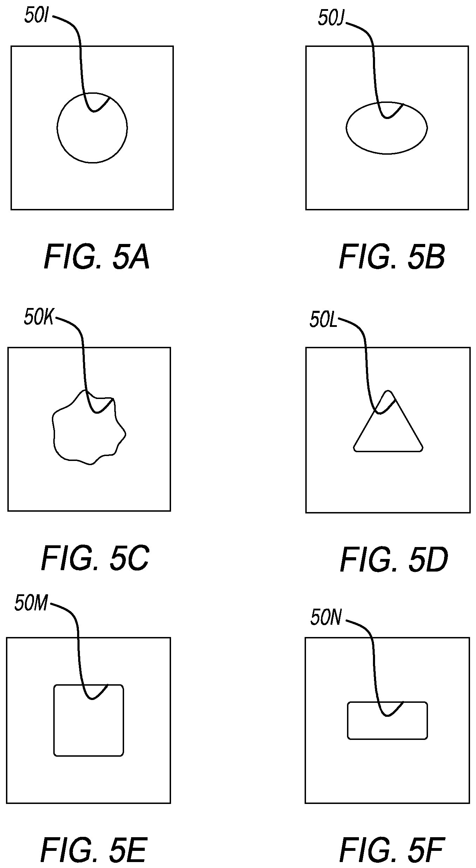

The capillary channels 50 are configured such that the oil from the TIM 130 can enter the capillary channels 50, so the capillary channels 50 are open near the oil or have an opening near the TIM 130. At the sidewalls 34 and the inner surface 22 of the cover 20, the capillary channels 50 may be either open channels or closed channels. The capillary channels 50 have any size and shape suitable for drawing oil released from the TIM 130 along the capillary channels 50 by capillary action. Exemplary shapes of open capillary channels 50 are illustrated in FIGS. 4A-4H. Exemplary shapes of closed capillary channels 50 are illustrated in FIGS. 5A-5L.

FIG. 4A illustrates an exemplary capillary channel 50A shaped as an open cylinder. The open cylinder may have any radius suitable to carry out the capillary action, such as a radius within the range of 0.3mm - 2.5mm, such as 1.0mm, for example. FIG. 4B illustrates an exemplary capillary channel 50B shaped as an open elliptical cylinder. FIG. 4C illustrates an exemplary capillary channel 50C shaped to have an open irregular channel geometry. FIG. 4D illustrates an exemplary capillary channel 50D shaped as an open triangular prism. FIG. 4E illustrates an exemplary capillary channel 50E shaped as an open rectangular prism. FIG. 4F illustrates an exemplary capillary channel 50F shaped as an open square prism. FIG. 4G illustrates an exemplary capillary channel 50G shaped as an open pentagonal prism. FIG. 4H illustrates an exemplary capillary channel 50H shaped as an open hexagonal prism.

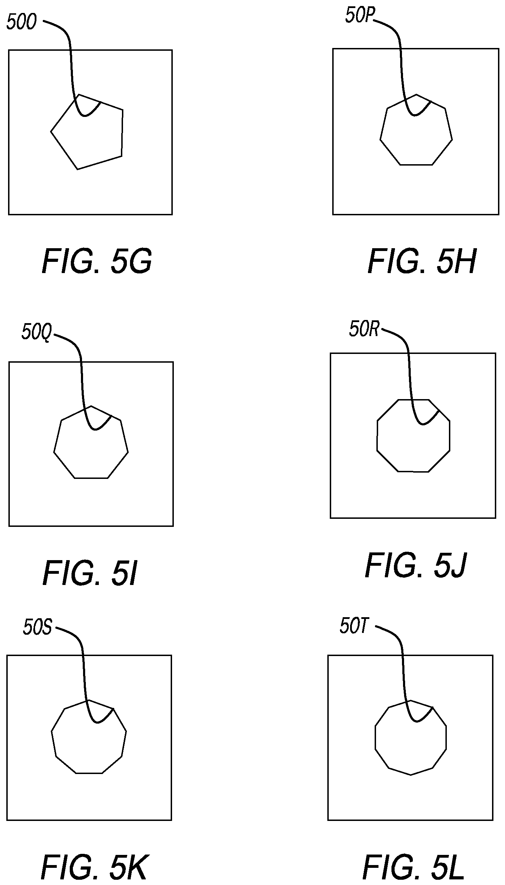

FIG. 5A illustrates an exemplary capillary channel 50I shaped as a closed cylinder. The channel 50I may have any radius suitable to carry out the capillary action, such as a radius within the range of 0.3mm - 2.5mm, such as 2.0mm, for example. FIG. 5B illustrates an exemplary capillary channel 50J shaped as a closed elliptical cylinder. FIG. 5C illustrates an exemplary capillary channel 50K shaped to have an irregular channel geometry. FIG. 5D illustrates an exemplary capillary channel 50L shaped as a triangular prism. FIG. 5E illustrates an exemplary capillary channel 50M shaped as a square prism. FIG. 5F illustrates an exemplary capillary channel 50N shaped as a rectangular prism. FIG. 5G illustrates an exemplary capillary channel 50O shaped as a pentagonal prism. FIG. 5H illustrates an exemplary capillary channel 50P shaped as a hexagonal prism. FIG. 5I illustrates an exemplary capillary channel 50Q shaped as a heptagonal prism. FIG. 5J illustrates an exemplary capillary channel 50R shaped as an octagonal prism. FIG. 5K illustrates an exemplary capillary channel 50S shaped as a nonagonal prism. FIG. 5L illustrates an exemplary capillary channel 50T shaped as a decagonal prism.

The present disclosure thus addresses the issue of oil seepage from the TIM 130 onto the IC 110, traces 122, etc. by including the capillary channels 50 with the heat sink 10. The capillary channels 50 are configured to use capillary action and the capillary force of the oil to direct the oil to collect in areas away from the TIM 130, traces 122, etc., which reduces the amount of bled oil that can migrate to the circuit board 120 and the traces 122. The present disclosure provides numerous other advantages as well, as one skilled in the art will appreciate.

The foregoing description of the embodiments has been provided for purposes of illustration and description. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms and that neither should be construed to limit the scope of the disclosure. In some example embodiments, well-known processes, well-known device structures, and well-known technologies are not described in detail.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (e.g., "between" versus "directly between," "adjacent" versus "directly adjacent," etc.). As used herein, the term "and/or" includes any and all combinations of one or more of the associated listed items.

Although the terms first, second, third, etc. may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath," "below," "lower," "above," "upper," and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

## Claims

1. A heat sink (10) configured to transfer heat away from an integrated circuit (110), the heat sink (10) comprising:
a base (32) configured to be mounted over the integrated circuit (110) in contact with thermal interface material (130) on the integrated circuit (110);
a sidewall (34) extending from the base (32); and
at least one capillary channel (50) extending along the base (32) away from the integrated circuit (110), the capillary channel (50) configured to draw oil released from the thermal interface material (130) away from the integrated circuit (110) by capillary action.

2. The heat sink of claim 1, wherein the capillary channel extends from the base to the sidewall and along the sidewall.

3. The heat sink of claim 1, wherein the capillary channel extends along or from the base to both the sidewall and an additional sidewall of the heat sink.

4. The heat sink of claim 1, wherein:
the capillary channel extends continuously from the base to the sidewall; and
the sidewall is oriented 90° relative to the base.

5. The heat sink of any one of the preceding claims, wherein at the base at least a portion of the capillary channel has the thermal interface material therein.

6. The heat sink of any one of the preceding claims, wherein the heat sink further comprises a pedestal including the base, and a plurality of sidewalls including the sidewall.

7. The heat sink of claim 6, wherein:
the heat sink further comprises a cover;
the pedestal extends from the cover; and
the capillary channel extends from the base to the sidewall, from the sidewall to the cover, and along a surface of the cover.

8. The heat sink of any one of the preceding claims, wherein the capillary channel is an open channel, in particular including a radius of 0.3mm - 2.5mm, or
a closed channel at the sidewall including a radius of 0.3mm - 2.5mm.

9. The heat sink of any one of the preceding claims, wherein the capillary channel is an open channel including one of an open cylinder, an open elliptical cylinder, an open irregular channel geometry, an open triangular prism, an open rectangular prism, an open square prism, an open pentagonal prism, and an open hexagonal prism.

10. The heat sink of claim 1, wherein the capillary channel is a closed channel at the sidewall and an open channel at the base.

11. The heat sink of claim 1, wherein:
the capillary channel is an open channel at the base; and
the capillary channel is a closed channel at the sidewall including one of a closed cylinder, a closed elliptical cylinder, a closed irregular channel geometry, a closed triangular prism, a closed square prism, a closed rectangular prism, a closed pentagonal prism, a closed hexagonal prism, a closed heptagonal prism, a closed octagonal prism, a closed nonagonal prism, and a closed decagonal prism.

12. The heat sink of claim 1, the heat sink comprising:
a plurality of sidewalls extending from the base, the plurality of sidewalls and the base defining a heat sink pedestal; and
a plurality of capillary channels extending from the base to and along at least one of the plurality of sidewalls, the plurality of capillary channels configured to draw oil released from the thermal interface material away from the integrated circuit by capillary action.

13. The heat sink of claim 12, wherein the plurality of capillary channels are open channels at the base and open or closed channels at the plurality of sidewalls.

14. The heat sink of claim 12 comprising:
a cover;
the pedestal extending from the cover towards an integrated circuit, the pedestal including
the plurality of capillary channels extending continuously from the base to at least two of the plurality of sidewalls, along the at least two of the plurality of sidewalls, and along the cover;
wherein the plurality of capillary channels are configured to draw oil released from the thermal interface material into the plurality of capillary channels and along the plurality of capillary channels away from the integrated circuit by capillary action.

15. The heat sink of claim 14, wherein the plurality of capillary channels are open channels at the base, and are open channels or closed channels along the at least two of the plurality of sidewalls and along the cover,
wherein the open channels have in particular a first radius that is less than a second radius of the closed channels.

## Patentansprüche

1. Kühlkörper (10), der eingerichtet ist, um Wärme von einer integrierten Schaltung (110) wegzuleiten, wobei der Kühlkörper (10) umfasst:
eine Basis (32), die eingerichtet ist, um über der integrierten Schaltung (110) in Kontakt mit Wärmeschnittstellenmaterial (130) auf der integrierten Schaltung (110) montiert zu werden;
eine Seitenwand (34), die sich von der Basis (32) erstreckt; und
mindestens einen Kapillarkanal (50), der sich entlang der Basis (32) von der integrierten Schaltung (110) weg erstreckt, wobei der Kapillarkanal (50) eingerichtet ist, durch Kapillarwirkung aus dem Wärmeschnittstellenmaterial (130) freigesetztes Öl von der integrierten Schaltung (110) wegzuleiten.

2. Kühlkörper nach Anspruch 1, wobei sich der Kapillarkanal von der Basis zu der Seitenwand und entlang der Seitenwand erstreckt.

3. Kühlkörper nach Anspruch 1, wobei sich der Kapillarkanal entlang der Basis oder von der Basis zu sowohl der Seitenwand als auch einer zusätzlichen Seitenwand des Kühlkörpers erstreckt.

4. Kühlkörper nach Anspruch 1, wobei:
sich der Kapillarkanal kontinuierlich von der Basis zu der Seitenwand erstreckt; und
die Seitenwand um 90° relativ zu der Basis ausgerichtet ist.

5. Kühlkörper nach einem der vorstehenden Ansprüche, wobei an der Basis mindestens ein Abschnitt des Kapillarkanals das Wärmeschnittstellenmaterial darin aufweist.

6. Kühlkörper nach einem der vorstehenden Ansprüche, wobei der Kühlkörper ferner einen Sockel, der die Basis einschließt, und eine Vielzahl von Seitenwänden umfasst, die die Seitenwand einschließen.

7. Kühlkörper nach Anspruch 6, wobei:
der Kühlkörper ferner eine Abdeckung umfasst;
der Sockel sich von der Abdeckung erstreckt; und
sich der Kapillarkanal von der Basis zu der Seitenwand, von der Seitenwand zu der Abdeckung und entlang einer Oberfläche der Abdeckung erstreckt.

8. Kühlkörper nach einem der vorstehenden Ansprüche, wobei der Kapillarkanal ein offener Kanal, insbesondere mit einem Radius von 0.3mm - 2.5mm, oder
ein geschlossener Kanal an der Seitenwand mit einem Radius von 0.3mm - 2.5mm ist.

9. Kühlkörper nach einem der vorstehenden Ansprüche, wobei der Kapillarkanal ein offener Kanal ist, einschließlich eines von einem offenen Zylinder, einem offenen elliptischen Zylinder, einer offenen unregelmäßigen Kanalgeometrie, einem offenen dreieckigen Prisma, einem offenen rechteckigen Prisma, einem offenen quadratischen Prisma, einem offenen fünfeckigen Prisma und einem offenen sechseckigen Prisma.

10. Kühlkörper nach Anspruch 1, wobei der Kapillarkanal ein geschlossener Kanal an der Seitenwand und ein offener Kanal an der Basis ist.

11. Kühlkörper nach Anspruch 1, wobei:
der Kapillarkanal ein offener Kanal an der Basis ist; und
der Kapillarkanal ein geschlossener Kanal an der Seitenwand ist, einschließlich eines von einem geschlossenen Zylinder, einem geschlossenen elliptischen Zylinder, einer geschlossenen unregelmäßigen Kanalgeometrie, einem geschlossenen dreieckigen Prisma, einem geschlossenen quadratischen Prisma, einem geschlossenen rechteckigen Prisma, einem geschlossenen fünfeckigen Prisma, einem geschlossenen sechseckigen Prisma, einem geschlossenen siebeneckigen Prisma, einem geschlossenen achteckigen Prisma, einem geschlossenen neuneckigen Prisma und einem geschlossenen zehneckigen Prisma.

12. Kühlkörper nach Anspruch 1, wobei der Kühlkörper umfasst:
eine Vielzahl von Seitenwänden, die sich von der Basis erstrecken, wobei die Vielzahl von Seitenwänden und die Basis einen Kühlkörpersockel definieren; und
eine Vielzahl von Kapillarkanälen, die sich von der Basis zu und entlang mindestens einer der Vielzahl von Seitenwänden erstrecken, wobei die Vielzahl von Kapillarkanälen eingerichtet ist, durch Kapillarwirkung aus dem Wärmeschnittstellenmaterial freigesetztes Öl von der integrierten Schaltung wegzuleiten.

13. Kühlkörper nach Anspruch 12, wobei die Vielzahl von Kapillarkanälen an der Basis offene Kanäle und an der Vielzahl von Seitenwänden offene oder geschlossene Kanäle sind.

14. Kühlkörper nach Anspruch 12, umfassend:
eine Abdeckung;
den Sockel, der sich von der Abdeckung in Richtung einer integrierten Schaltung erstreckt, wobei der Sockel die Vielzahl von Kapillarkanälen umfasst, die sich kontinuierlich von der Basis zu mindestens zwei der Vielzahl von Seitenwänden, entlang der mindestens zwei der Vielzahl von Seitenwänden und entlang der Abdeckung erstrecken;
wobei die Vielzahl von Kapillarkanälen eingerichtet ist, durch Kapillarwirkung aus dem Wärmeschnittstellenmaterial freigesetztes Öl in die Vielzahl von Kapillarkanälen und entlang der Vielzahl von Kapillarkanälen von der integrierten Schaltung wegzuleiten.

15. Kühlkörper nach Anspruch 14, wobei die Vielzahl von Kapillarkanälen offene Kanäle an der Basis sind und offene Kanäle oder geschlossene Kanäle entlang der mindestens zwei der Vielzahl von Seitenwänden und entlang der Abdeckung sind,
wobei die offenen Kanäle insbesondere einen ersten Radius haben, der kleiner als ein zweiter Radius der geschlossenen Kanäle ist.

## Revendications

1. Dissipateur thermique (10) configuré pour transférer de la chaleur en éloignement d'un circuit intégré (110), le dissipateur thermique (10) comprenant :
une base (32) configurée pour être montée au-dessus du circuit intégré (110) en contact avec un matériau d'interface thermique (130) sur le circuit intégré (110) ;
une paroi latérale (34) s'étendant depuis la base (32) ; et
au moins un canal capillaire (50) s'étendant le long de la base (32) en éloignement du circuit intégré (110), le canal capillaire (50) étant configuré pour aspirer, par action capillaire, de l'huile libérée du matériau d'interface thermique (130) en éloignement du circuit intégré (110).

2. Dissipateur thermique selon la revendication 1, dans lequel le canal capillaire s'étend depuis la base jusqu'à la paroi latérale et le long de la paroi latérale.

3. Dissipateur thermique selon la revendication 1, dans lequel le canal capillaire s'étend le long de la base ou depuis la base jusqu'à la fois la paroi latérale et une paroi latérale supplémentaire du dissipateur thermique.

4. Dissipateur thermique selon la revendication 1, dans lequel :
le canal capillaire s'étend en continu depuis la base jusqu'à la paroi latérale ; et
la paroi latérale est orientée à 90° par rapport à la base.

5. Dissipateur thermique selon l'une des revendications précédentes, dans lequel au niveau de la base au moins une portion du canal capillaire contient le matériau d'interface thermique à l'intérieur.

6. Dissipateur thermique selon l'une des revendications précédentes, dans lequel le dissipateur thermique comprend en outre un socle incluant la base, et une pluralité de parois latérales incluant la paroi latérale.

7. Dissipateur thermique selon la revendication 6, dans lequel :
le dissipateur thermique comprend en outre une couverture ;
le socle s'étend depuis la couverture ; et
le canal capillaire s'étend depuis la base jusqu'à la paroi latérale, depuis la paroi latérale jusqu'à la couverture, et le long d'une surface de la couverture.

8. Dissipateur thermique selon l'une des revendications précédentes, dans lequel le canal capillaire est un canal ouvert, incluant en particulier un rayon de 0,3 mm à 2,5 mm, ou
un canal fermé au niveau de la paroi latérale incluant un rayon de 0,3 mm à 2,5 mm.

9. Dissipateur thermique selon l'une des revendications précédentes, dans lequel le canal capillaire est un canal ouvert incluant l'un parmi un cylindre ouvert, un cylindre elliptique ouvert, une géométrie de canal irrégulière ouverte, un prisme triangulaire ouvert, un prisme rectangulaire ouvert, un prisme carré ouvert, un prisme pentagonal ouvert et un prisme hexagonal ouvert.

10. Dissipateur thermique selon la revendication 1, dans lequel le canal capillaire est un canal fermé au niveau de la paroi latérale et un canal ouvert au niveau de la base.

11. Dissipateur thermique selon la revendication 1, dans lequel :
le canal capillaire est un canal ouvert au niveau de la base ; et
le canal capillaire est un canal fermé au niveau de la paroi latérale incluant l'un parmi un cylindre fermé, un cylindre elliptique fermé, une géométrie de canal irrégulière fermée, un prisme triangulaire fermé, un prisme carré fermé, un prisme rectangulaire fermé, un prisme pentagonal fermé, un prisme hexagonal fermé, un prisme heptagonal fermé, un prisme octogonal fermé, un prisme nonagonal fermé et un prisme décagonal fermé.

12. Dissipateur thermique selon la revendication 1, le dissipateur thermique comprenant :
une pluralité de parois latérales s'étendant depuis la base, la pluralité de parois latérales et la base définissant un socle de dissipateur thermique ; et
une pluralité de canaux capillaires s'étendant depuis la base jusqu'à et le long d'au moins une de la pluralité de parois latérales, la pluralité de canaux capillaires étant configurés pour aspirer, par action capillaire, de l'huile libérée du matériau d'interface thermique en éloignement du circuit intégré.

13. Dissipateur thermique selon la revendication 12, dans lequel la pluralité de canaux capillaires sont des canaux ouverts au niveau de la base et des canaux ouverts ou fermés au niveau de la pluralité de parois latérales.

14. Dissipateur thermique selon la revendication 12 comprenant :
un couvercle ;
le socle s'étendant depuis le couvercle en direction d'un circuit intégré, le socle incluant
la pluralité de canaux capillaires s'étendant continûment depuis la base jusqu'à au moins deux de la pluralité de parois latérales, le long des au moins deux de la pluralité de parois latérales et le long du couvercle ;
dans lequel la pluralité de canaux capillaires est configurée pour aspirer, par action capillaire, de l'huile libérée du matériau d'interface thermique dans la pluralité de canaux capillaires et le long de la pluralité de canaux capillaires à l'écart du circuit intégré.

15. Dissipateur thermique selon la revendication 14, dans lequel la pluralité de canaux capillaires sont des canaux ouverts au niveau de la base et sont des canaux ouverts ou fermés le long des au moins deux de la pluralité de parois latérales et le long du couvercle,
dans lequel les canaux ouverts ont en particulier un premier rayon qui est inférieur à un second rayon des canaux fermés.
